# EUROPÄISCHE PATENTSCHRIFT

(11) **EP 1 442 344 B1**
(45) Veröffentlichungstag und Bekanntmachung des Hinweises auf die Patenterteilung: **25.01.2006**
(21) Anmeldenummer: 02783024.9
(22) Anmeldetag: 29.10.2002
(51) Int. Cl.: G05D 7/06

(54) **VERFAHREN UND VORRICHTUNG ZUR BEHANDLUNG VON GEGENSTÄNDEN MITTELS EINER FLÜSSIGKEIT**
METHOD AND DEVICE FOR TREATING OBJECTS BY MEANS OF A LIQUID
PROCEDE ET DISPOSITIF POUR TRAITER DES OBJETS A L'AIDE D'UN LIQUIDE

(30) Priorität: 05.11.2001 DE 10154885
(43) Veröffentlichungstag der Anmeldung: 04.08.2004
(73) Patentinhaber: Gebr. Schmid GmbH & Co., 72238 Freudenstadt (DE)
(72) Erfinder: SCHMID, Christian, 72250 Freudenstadt (DE)
(74) Vertreter: Renger, Florian
(86) Internationale Anmeldenummer: PCT/EP2002/012040
(87) Internationale Veröffentlichungsnummer: WO 2003/041461

(56) Entgegenhaltungen:
- DE-A- 3 345 125
- US-A- 3 756 898
- US-A- 5 002 627
- US-A- 5 290 384

## Beschreibung

### Anwendungsgebiet und Stand der Technik

Die Erfindung betrifft ein Verfahren gemäß dem Oberbegriff von Anspruch 1 sowie eine Vorrichtung gemäß dem Oberbegriff von Anspruch 10 zur Behandlung von Gegenständen, wie beispielsweise Substraten in der Leiterplattenindustrie, mittels einer Flüssigkeit.

Dabei werden in der Regel Gegenstände bzw. Substrate oder sogenannte Leiterplatten verwendet, die an der Oberfläche eine Schicht, beispielsweise eine Schicht aus leitfähigem Material wie Kupfer, aufweisen. Diese Schicht wird unter der Einwirkung der Flüssigkeit, welche insbesondere ein Ätzmittel sein kann, unter Ausbildung eines Musters entfernt. Die Flüssigkeit wird dabei mittels Düsen, welche mit einem Flüssigkeitsanschluß verbunden sind, ausgebracht.

Hier besteht nun vielfach das Problem, dass solche Düsen als eine Art Düsenfeld in größerer Anzahl nebeneinander und auch hintereinander vorgesehen sind. Unter diesem Düsenfeld werden die Substrate flachliegend durchgefahren und dabei mit der Flüssigkeit besprüht. Hierbei ergibt sich das Problem, dass damit zwar grundsätzlich eine völlig gleichverteilte Flüssigkeitsbeaufschlagung der Substrate erfolgt. Da aber in den Außenbereichen die Flüssigkeit leicht zum Rande hin abfließen kann, ist hier der Flüssigkeitsaustausch größer bzw. es wird sehr viel mehr frische Ätzflüssigkeit aufgebracht. Im Mittelbereich dagegen bildet sich eine Art Flüssigkeitsstau (sogenannter Pfützeneffekt) und der Austausch an Flüssigkeit ist weitaus geringer. Dies führt im Endergebnis dazu, dass in den Außenbereichen weitaus mehr von der Schicht weggeätzt wird als im Mittelbereich und somit das Ergebnis verschlechtert oder unter Umständen ein Substrat unbrauchbar wird.

Zur Beseitigung dieses Problems ist es aus der DE 33 45 125 bekannt, in den Außenbereichen des Substrats weniger Flüssigkeit aufzubringen bzw. den Durchfluß zu verringern. Dazu sind in den Zuleitungen zu den Düsen Regelventile und Durchflussmesser vorgesehen. Durch die hierfür notwendigen Durchflussmesser ist diese Vorrichtung sehr aufwändig. Das Regeln der Ventile ist ebenfalls nicht leicht, es werden aufwändige Ventile benötigt.

### Aufgabe und Lösung

Der Erfindung liegt die Aufgabe zugrunde, ein eingangs genanntes Verfahren sowie eine Vorrichtung zu schaffen, durch welche die Flüssigkeitsbeaufschlagung solcher Gegenstände individuell und gewünscht möglich ist. Das erfindungsgemäße Verfahren sowie die Vorrichtung sollen dabei möglichst einfach gehalten werden.

Gelöst wird diese Aufgabe durch ein Verfahren mit den Merkmalen des Anspruchs 1 sowie eine Vorrichtung mit den Merkmalen des Anspruchs 10. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Anmeldung gemacht.

Bei dem erfindungsgemäßen Verfahren ist ein Flüssigkeitsanschluß für die Düsen mit einem Flüssigkeitsvorrat verbunden und kann geöffnet und geschlossen werden. Jeder Düse ist ein Ventil direkt zugeordnet mit möglichst geringem Abstand dazu. Auf diese Weise ist vorteilhaft eine äußerst verzögerungsfreie Steuerung der Flüssigkeitsbeaufschlagung durch die Düse möglich. Die Ventile werden dabei einzeln zum Öffnen oder Schließen angesteuert. Dies kann jedoch ebenso zwar einzeln, aber in Gruppen gleichzeitig erfolgen. So ist eine individuell beliebige Flüssigkeitsbeaufschlagung bzw. ein dadurch gebildetes Flüssigkeitsaustragsbild möglich.

Die Gegenstände werden entlang einer Bewegungsbahn relativ zu den Düsen bewegt, vorteilhaft mit kontinuierlicher Geschwindigkeit. Durch Öffnen und Schließen der Ventile kann einerseits bei geöffnetem Flüssigkeitsanschluß ein bestimmter Flüssigkeitsaustrag mit einer über die Bewegungsbahn vorbestimmten Flächenverteilung erzeugt werden. Alternativ ist es möglich, zusätzlich die Flüssigkeitsanschlüsse zu öffnen oder zu schließen, um diese Flächenverteilung zu erzielen.

Die Flüssigkeitsanschlüsse sind dazu mit Vorteil länglich ausgeführt, wobei sie mehrere Düsen aufweisen, die einen bestimmten Abstand zueinander haben. Die Flüssigkeitsanschlüsse können bevorzugt über einen Verschluß geöffnet und geschlossen werden. Bei einer bevorzugten Ausführung sind mehrere solcher Flüssigkeitsanschlüsse parallel zueinander und hintereinander angeordnet. Dadurch können sie eine Fläche über der Bewegungsbahn der Gegenstände bedecken. Besonders bevorzugt werden die Flüssigkeitsanschlüsse einzeln angesteuert und geöffnet bzw. verschlossen, je nach vorbestimmter Flächenverteilung auch unabhängig und unterschiedlich.

Vorteilhaft sind die Flüssigkeitsanschlüsse ortsfest und die Gegenstände bewegen sich auf einer Bewegungsbahn. Diese Bewegungsbahn kann eine Transportbahn sein, beispielsweise eine Rollenbahn oder dergleichen. Bevorzugt sind zumindest oberhalb der Bewegungsbahn der Gegenstände Flüssigkeitsanschlüsse vorgesehen und bringen die Flüssigkeit von oben auf die Gegenstände auf.

Bei einer Ausführungsmöglichkeit der Erfindung werden zur Erzielung der Flächenverteilung ausschließlich die Ventile der Düsen angesteuert. Damit kann sich eine Steuerung des Vorgangs auf die Ventile der Düsen beschränken. Bei einer anderen Ausführungsmöglichkeit der Erfindung können die Düsen der Ventile und auch die Verschlüsse der Flüssigkeitsanschlüsse geöffnet und geschlossen werden zur Erzielung der Flächenverteilung. Dabei werden in einem ersten Schritt die Düsen mittels der Ventile voreingestellt bzw. geöffnet oder geschlossen. Während des Vorgangs selber werden die Flüssigkeitsanschlüsse bzw. deren Verschlüsse geöffnet und geschlossen. Somit wird sozusagen über die Ventile der Düsen die Flüssigkeitsverteilung voreingestellt und dann mittels Öffnen und Schließen der Anschlüsse der Flüssigkeitsaustrag selber aktiviert. Auf diese Weise können die Ventile geschont werden und brauchen nicht ständig betätigt bzw. umgestellt werden. Da ein Flüssigkeitsanschluß eine Vielzahl von Düsen trägt, ist es leichter, den Flüssigkeitsaustrag über diesen Flüssigkeitsanschluß zu takten.

Bei dem erfindungsgemäßen Verfahren wird zur Vermeidung eines zu starken Flüssigkeitsauftrags in den Außenbereichen eines Substrats an den seitlichen und/oder an den vorderen und hinteren Außenbereichen der Substrate weniger Flüssigkeit aufgebracht als in einem mittleren Bereich. Dabei kann grundsätzlich der Flüssigkeitsauftrag beliebig verringert werden. Bevorzugt ist er mengenmäßig geringer, was besonders bevorzugt durch zeitliche Verringerung erfolgt. Dies bedeutet, dass der Flüssigkeitsdurchfluß durch eine Düse, sofern er überhaupt stattfindet, in jedem Fall gleich ist. In den betroffenen Außenbereichen bzw. für diese werden die betreffenden Düsen jedoch zeitlich häufiger oder länger abgeschaltet bzw. seltener aktiviert.

Vorteilhaft sind die Düsen ortsfest angeordnet. Gemäß einer Möglichkeit der Erfindung sind die Düsen starr und mit einer festgelegten Austragrichtung ausgelegt. Gemäß einer anderen, aufwändigeren Möglichkeit können die Düsen in ihrer Ausrichtung bewegt bzw. verändert werden. Dies kann für jede Düse einzeln oder in Gruppen erfolgen. Die Änderung der Ausrichtung kann sowohl in einer Richtung bzw. in einer Ebene, in mehreren Ebenen oder völlig frei wählbar erfolgen. Es ist möglich, durch das Vorsehen von Antrieben die Düsen gesteuert und beispielsweise elektromotorisch auszurichten. Solche Gruppen von Düsen können nach Flüssigkeitsanschlüssen aufgeteilt sein, beispielsweise zusammen mit dem Flüssigkeitsanschluß in Form eines Rohres oder dergleichen. Mit derart einstellbaren Düsen kann ein noch feinerer und beliebig erzielbarer Flüssigkeitsaustrag erreicht werden.

Bei einer Ausführungsmöglichkeit der Erfindung kann vorgesehen sein, dass in Durchlaufrichtung der Gegenstände gesehen im vorderen Bereich nur eine oder wenige Düsen Flüssigkeit austragen. In Durchlaufrichtung tragen zunehmend mehr Düsen Flüssigkeit aus, die damit vorteilhaft eine größere Fläche abdecken bzw. eine größere Ausdehnung aufweisen. Somit kann eine Flächenverteilung erzeugt werden, die keilförmig ist und sich in Durchlaufrichtung verbreitert. Es ist weiters möglich, bei einem erfindungsgemäßen Verfahren mehrere Gegenstände nebeneinander durchlaufen zu lassen. Hier kann für jeden Gegenstand ein bestimmtes, beispielsweise ein keilförmiges, Profil erzeugt werden. Es kann auch für jeden Gegenstand ein eigenes anderes Profil erzeugt werden.

Eine Möglichkeit zur Betätigung von Ventilen der Düsen ist mittels Druckluft. Dies ist relativ einfach und doch zuverlässig und wartungsarm. Es können Druckluftleitungen direkt an die Ventile geführt sein.

Diese und weitere Merkmale gehen außer aus den Ansprüchen aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: ein erfindungsgemäßes Düsenrohr in seitlichem Teilschnitt mit einer Vielzahl von daran angeordneten Austrageinheiten mit Düsen;
- Fig. 2: ein vergrößerter Ausschnitt aus Fig. 1 mit einem Schnitt durch eine solche Austrageinheit;
- Fig. 3: einen weiteren Schnitt durch die Austrageinheit aus Fig. 2 mit der Düse und
- Fig. 4 bis 6: verschiedene schematische Darstellungen von Düsenfeldern mit Verteilungsprofilen und Leiterplatten unterschiedlicher Formate.

### Detaillierte Beschreibung der Ausführungsbeispiele

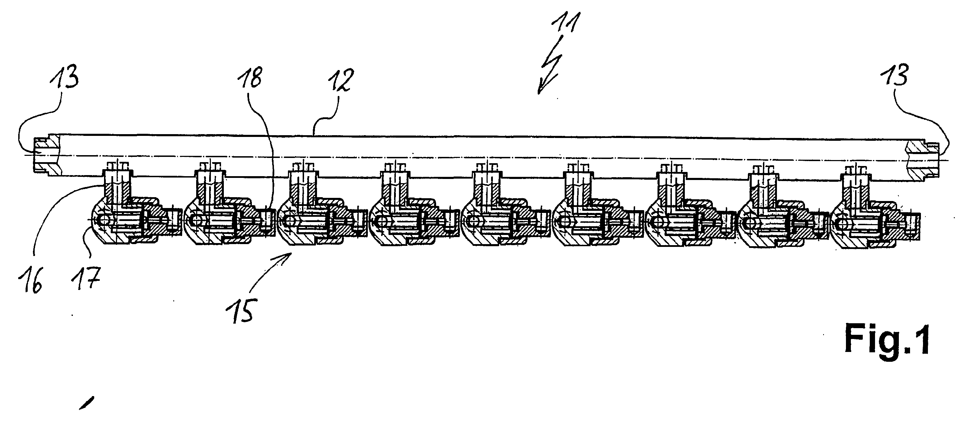

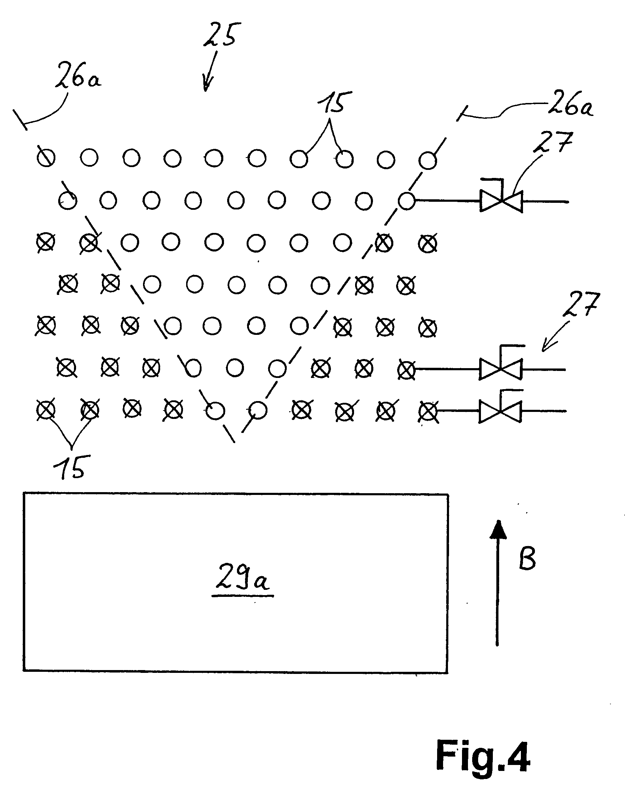

In Fig. 1 ist in seitlicher Ansicht eine erfindungsgemäße Vorrichtung 11 dargestellt mit einem Düsenrohr 12. Das Düsenrohr 12 hat links und rechts Flüssigkeitszuläufe 13, die das Düsenrohr 12 durchziehen. Das Düsenrohr 12 ist über in Fig. 4 schematisch dargestellte Verschlüsse öffen- und schließbar. Die Verschlüsse 27 der Düsenrohre 12 können über Druckluft betätigt werden.

Das Düsenrohr 12 trägt Austrageinheiten 15, die gleichen Abstand zueinander haben und identisch ausgebildet sind. Die Austrageinheiten 15 sind mittels eines Anschlussstücks 16 flüssigkeitsleitend mit dem Düsenrohr 12 verbunden. Des weiteren weisen sie eine Ventileinheit 17 mit einem Druckluftanschluß 18 zur Ansteuerung auf. Bei anderen Ausführungen können die Austrageinheiten 15 mit unterschiedlichen Abständen an dem Düsenrohr 12 angeordnet sein. Ebenso ist es möglich, verschiedenartig ausgebildete Austrageinheiten vorzusehen. Sie können auch an beiden Seiten des Düsenrohrs 12 angeschlossen sein.

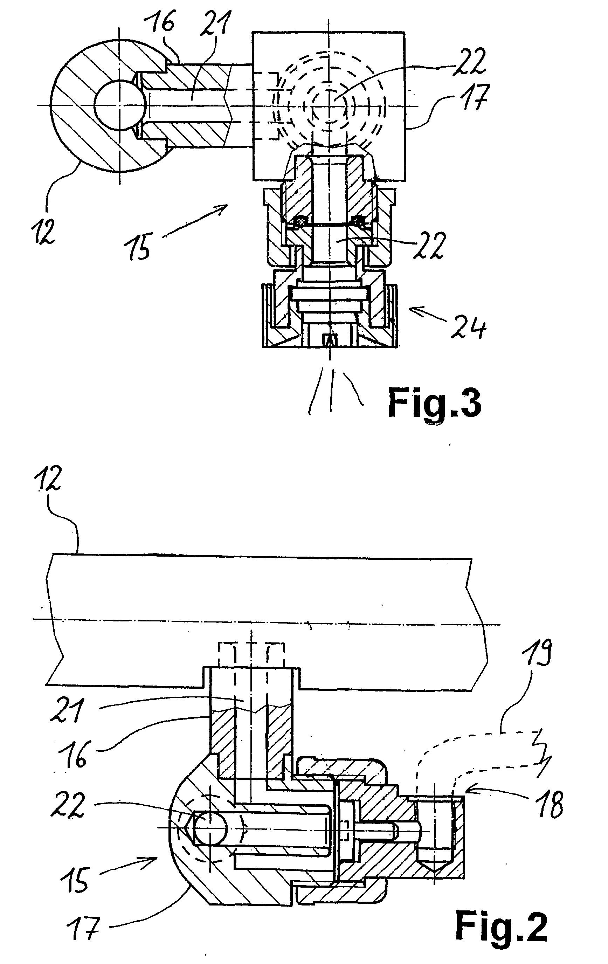

In Fig. 2 ist eine Austrageinheit 15 an dem Düsenrohr 12 gemäß der Darstellung aus Fig. 1 vergrößert dargestellt. In dem Druckluftanschluß 18 verläuft eine Druckluftleitung 19. Diese ist mit einer nicht dargestellten Drucklufteinheit verbunden. Jede Druckluftleitung 19 und somit jede Austrageinheit 15 kann einzeln über die Druckluftleitung 19 angesteuert werden.

Die flüssigkeitsleitende Verbindung mit dem Düsenrohr 12 erfolgt über den Flüssigkeitskanal 21 durch das Anschlussstück 16. Der Flüssigkeitskanal 21 durchzieht ebenso die Ventileinheit 17, wobei ein mittels des Druckluftanschlusses 18 betätigbares Membranventil zum Öffnen und Schließen vorgesehen ist. Auf dieses braucht an dieser Stelle nicht näher eingegangen zu werden. Der Flüssigkeitskanal 21 mündet in den Düsenzulauf 22, der in die Zeichenebene hinein verläuft.

Aus der Fig. 2 ist zum einen ersichtlich, dass die Austrageinheit 15 bzw. die Düse sehr nah an dem Düsenrohr 12 angeordnet ist. Zum anderen kann man daraus ersehen, dass die Ventileinheit 17 und damit die Beeinflussung, ob die Düse 24 arbeitet oder nicht, direkt an der Düse vorgesehen ist. Somit ist eine sehr genaue und zeitnahe Beeinflussung der Düse möglich.

Aus der Darstellung in Fig. 3 ist erkennbar, wie unterhalb der Ventileinheit 17 die Düse 24 angeordnet ist. Sie sind durch den Düsenzulauf 22 flüssigkeitsleitend verbunden. Auf die genaue Ausbildung der Düse 24 braucht hier nicht eingegangen zu werden, da sie aus der Fig. 3 ersichtlich ist sowie im wesentlichen bekannten Düseneinheiten entspricht.

Von der Düse 24 aus geht ein Düsenstrahl nach unten. Dieser kann bezüglich seines Profils oder seiner Weite an der Düse 24 selber eingestellt werden. Dies kann manuell oder automatisiert gesteuert erfolgen.

In Fig. 4 ist schematisch ein Düsenfeld 25 dargestellt. Dieses besteht aus einer Vielzahl von Austrageinheiten 15. Diese sind nebeneinander an Düsenrohren 12 entsprechend Fig. 1 angeordnet. Diese Düsenrohre, die selber in Fig. 4 nicht dargestellt sind, sind mittels der Verschlüsse 27 flüssigkeitsleitend steuerbar.

Es ist zu erkennen, dass einige der Austrageinheiten 15 durchgestrichen sind. Dies bedeutet, dass sie im Betrieb mittels der Ventileinheiten 17 gesperrt sind und keinen Flüssigkeitsaustrag bewirken. Somit ergibt sich aus den aktiven Austrageinheiten 15 ein Verteilungsprofil 26a, das durch die gestrichelte Linie verdeutlicht ist. Wie daraus zu entnehmen ist, ist das Verteilungsprofil 26a in der Fig. 4 keilförmig.

Eine Leiterplatte 29a bewegt sich in Bewegungsrichtung B unter dem Düsenfeld 25 durch. Der Flüssigkeitsaustrag auf die Leiterplatte 29a wird durch das Verteilungsprofil 26a vorgegeben. Daraus kann man erkennen, dass der Flüssigkeitsaustrag in einem Zentralbereich der Leiterplatte 29a bzw. einem Mittelstreifen stärker ist als zum Rand hin, da hier mehr Düsen aktiviert sind.

Der Flüssigkeitsaustrag erfolgt hier derart, dass die Austrageinheiten 15 zur Voreinstellung über die Ventileinheiten 17 entsprechend dem Verteilungsprofil 26a geöffnet oder geschlossen werden. Ein Ansteuern der Austrageinheiten 15 erfolgt dann mittels der Verschlüsse 27 über die Düsenrohre 12. Wie vorstehend erläutert wurde, können damit die Ventileinheiten 17 geschont werden, da sie nicht so oft betätigt werden müssen.

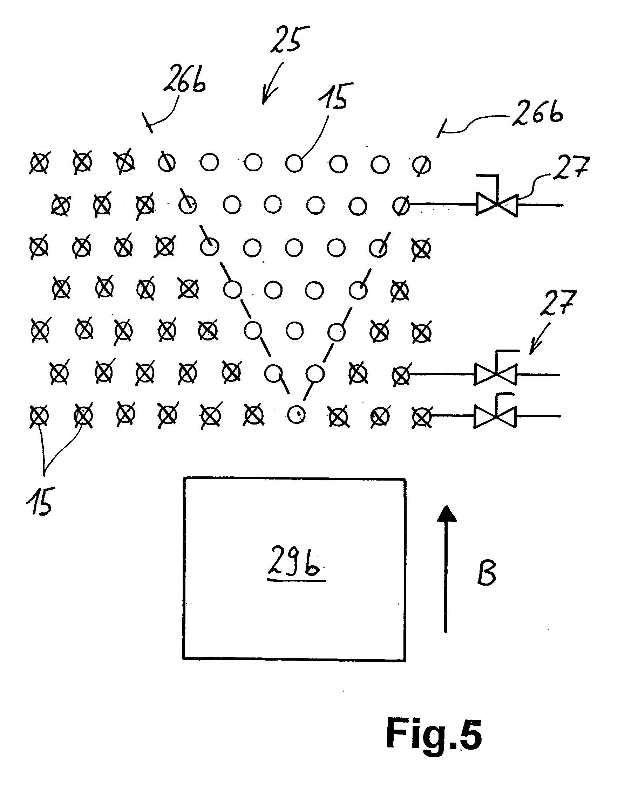

In Fig. 5 ist wiederum das Düsenfeld 25 aus Fig. 4 dargestellt. Da hier die Leiterplatte 29b eine geringere Breite aufweist, ist das keilförmige Verteilungsprofil 26b spitzer zulaufend bzw. auf deren Breite abgestimmt. Des weiteren ist hier die Leiterplatte 29b gegenüber der Mittelachse des Düsenfeldes 25 nach rechts verschoben. Ebenso ist das Verteilungsprofil 26b deswegen nach rechts verschoben.

Um eine Anpassung an eine in Bewegungsrichtung B kürzere Leiterplatte vorzunehmen, ist es möglich, ganze Reihen von Austrageinheiten 15 bzw. Düsenrohre 12, die sich senkrecht zur Bewegungsrichtung B erstrecken, abzuschalten.

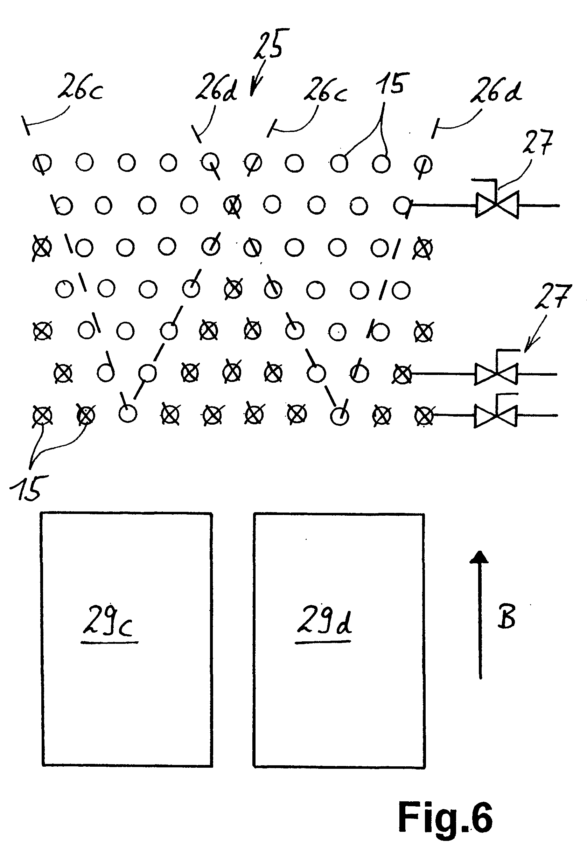

In Fig. 6 ist ebenfalls das Düsenfeld 25 aus Fig. 4 dargestellt. Hier sind zwei nebeneinander liegende Leiterplatten 29c und 29d mit Flüssigkeit zu beaufschlagen. Daraus ergibt sich das Verteilungsprofil 26c bzw. 26d, das wiederum durch gestrichelte Linien dargestellt ist. Auch diese Verteilungsprofile sind keilförmig entgegen der Bewegungsbahn B gerichtet. Im oberen mittleren Bereich der Austrageinheiten 15 überschneiden sich die beiden Verteilungsprofile. Dies stellt jedoch in der Praxis keinerlei Probleme dar.

Würden die beiden Leiterplatten 29c und 29d in Bewegungsrichtung B zueinander verschoben sein, so wären die Verteilungsprofile 26 an sich die gleichen. Lediglich der zeitliche Einsatz wäre unterschiedlich und jeweils für jede Leiterplatte einzeln abgestimmt.

Nicht dargestellt ist in den Figuren eine Ansteuerung für das Austragen der Flüssigkeit. Eine solche Ansteuerung kann insbesondere eine Sensorik aufweisen, die Position, Ausrichtung und Größe der Leiterplatten erfasst und darauf abgestimmt den Flüssigkeitsaustrag bzw. ein entsprechendes Verteilungsprofil erstellt und für den Flüssigkeitsaustrag verwendet.

## Patentansprüche

1. Verfahren zur Behandlung von Gegenständen, insbesondere Substraten (29) in der Leiterplattenindustrie, mittels einer Flüssigkeit, wobei:
- die Gegenstände (29) weisen an der Oberfläche eine Schicht auf, welche unter der Einwirkung der Flüssigkeit unter Ausbildung eines Musters teilweise entfernt wird,
- mehrere Düsen (24) sind zum Austragen der Flüssigkeit vorgesehen und mit wenigstens einem Flüssigkeitsanschluß (12) verbunden,
- der Flüssigkeitsanschluß (12) ist mit einem Flüssigkeitsvorrat verbunden,
**dadurch gekennzeichnet dass**:
- der Flüssigkeitsanschluß (12) ist öffenbar und verschließbar,
- direkt an jeder Düse (24) ist ein Ventil (17) vorgesehen
- die Ventile (17) sind einzeln zum Öffnen oder Schließen ansteuerbar,
- die Gegenstände (29) werden entlang einer Bewegungsbahn (B) relativ zu den Düsen (24) bewegt,
- mittels Öffnen und Schließen der Ventile (17) und/oder der Flüssigkeitsanschlüsse (12) wird ein bestimmter Flüssigkeitsaustrag mit einer über eine Bewegungsbahn vorbestimmten oder vorbestimmbaren Flächenverteilung (26) erzeugt.

2. Verfahren nach Anspruch 1, **dadurch gekennzeichnet, dass** die Flüssigkeitsanschlüsse (12) länglich sind, mehrere Düsen (24) mit Abstand zueinander aufweisen und jeweils über einen Verschluß (27) öffenbar und verschließbar sind, wobei mehrere Flüssigkeitsanschlüsse (12) parallel zueinander und hintereinander zur Bedeckung einer Fläche über der Bewegungsbahn (B) angeordnet sind und insbesondere einzeln steuerbar sind.

3. Verfahren nach Anspruch 1 oder 2, **dadurch gekennzeichnet, dass** die Flüssigkeitsanschlüsse (12) relativ zu der Bewegungsbahn (B) hintereinander ortsfest angeordnet sind und die Gegenstände (29 entlang der Bewegungsbahn (B) bewegt werden.

4. Verfahren nach einem der vorhergehenden Ansprüche, **dadurch gekennzeichnet, dass** zur Erzielung einer bestimmten Flächenverteilung (26) des Flüssigkeitsaustrags über der Bewegungsbahn (B) die Ventile (17) der Düsen (24) angesteuert werden.

5. Verfahren nach Anspruch 4, **dadurch gekennzeichnet, dass** zur Erzielung der Flächenverteilung (26) ausschließlich die Ventile (17) der Düsen (24) angesteuert werden.

6. Verfahren nach einem der Ansprüche 1 bis 4, **dadurch gekennzeichnet, dass** zur Erzielung der Flächenverteilung (26) im Durchlauf der Gegenstände (29) in einem ersten Schritt die Düsen (24) mittels der Ventile (17) voreingestellt werden und in einem zweiten Schritt die Flüssigkeitsanschlüsse (12) geöffnet und geschlossen werden zum Takten.

7. Verfahren nach einem der vorhergehenden Ansprüche, **dadurch gekennzeichnet, dass** zur Erzielung einer bestimmten Flächenverteilung (26) des Flüssigkeitsaustrags an den seitlichen und/oder vorderen und hinteren Außenbereichen der Gegenstände (29) weniger Flüssigkeit aufgebracht wird als in einem mittleren Bereich, wobei vorzugsweise der Flüssigkeitsauftrag mengenmäßig und zeitlich weniger ist.

8. Verfahren nach einem der vorhergehenden Ansprüche, **dadurch gekennzeichnet, dass** die Düsen (24) in ihrer Ausrichtung bewegt bzw. verändert werden, wobei vorzugsweise die Düsen (24) einzeln oder in Gruppen verändert werden und insbesondere die Gruppen nach Flüssigkeitsanschlüssen (12) aufgeteilt sind.

9. Verfahren nach einem der vorhergehenden Ansprüche, **dadurch gekennzeichnet, dass** in Durchlaufrichtung der Gegenstände (29) entlang der Bewegungsbahn (B) von den vorderen Düsen (24) nur eine oder wenige Düsen Flüssigkeit austragen und in Durchlaufrichtung zunehmend mehr Düsen, vorzugsweise unter Abdeckung einer größeren Fläche, Flüssigkeit austragen.

10. Vorrichtung zur Behandlung von Gegenständen, insbesondere Substraten (29) in der Leiterplattenindustrie, mittels einer Flüssigkeit, insbesondere zur Durchführung des Verfahrens nach einem der vorhergehenden Ansprüche, wobei:
- die Gegenstände (29) weisen an der Oberfläche eine Schicht auf, welche unter der Einwirkung der Flüssigkeit unter Ausbildung eines Musters teilweise entfernt wird,
- mehrere Düsen (24) sind zum Austragen der Flüssigkeit vorgesehen und mit wenigstens einem Flüssigkeitsanschluß (12) verbunden,
- der Flüssigkeitsanschluß (12) ist mit einem Flüssigkeitsvorrat verbunden,
**dadurch gekennzeichnet dass**:
- der Flüssigkeitsanschluß (12) ist öffenbar und verschließbar,
- direkt an jeder Düse (24) ist ein Ventil (17) vorgesehen
- die Ventile (17) sind einzeln zum Öffnen oder Schließen ansteuerbar,
- die Gegenstände (29) werden entlang einer Bewegungsbahn (B) relativ zu den Düsen (24) bewegt,
- die Ventile (17) und/oder der Flüssigkeitsanschluss (12) sind öffenbar und schließbar zur Erzeugung eines bestimmten Flüssigkeitsaustrags mit einer über eine Bewegungsbahn (B) vorbestimmten Flächenverteilung (26).

11. Vorrichtung nach Anspruch 10, **dadurch gekennzeichnet, dass** der Flüssigkeitsanschluß (12) länglich ist, mehrere Düsen (24) mit Abstand zueinander aufweist und über einen Verschluß (27) öffenbar und verschließbar ist, wobei vorzugsweise mehrere Flüssigkeitsanschlüsse (12) parallel zueinander und hintereinander zur Bedeckung einer Fläche über der Bewegungsbahn (B) angeordnet sind und insbesondere einzeln ansteuerbar sind.

12. Vorrichtung nach Anspruch 10 oder 11, **dadurch gekennzeichnet, dass** die Flüssigkeitsanschlüsse (12) relativ zu der Bewegungsbahn (B) hintereinander ortsfest angeordnet sind, wobei vorzugsweise die Gegenstände (29) auf einer Transportbahn, insbesondere einer Rollenbahn, unter den Flüssigkeitsanschlüssen (12) bewegbar sind.

13. Vorrichtung nach einem der Ansprüche 10 bis 12, **dadurch gekennzeichnet, dass** die Ventile (17) der Düsen (24) ansteuerbar sind, insbesondere einzeln, zur Erzielung einer bestimmten Flächenverteilung (26) des Flüssigkeitsaustrags über der Bewegungsbahn (B).

14. Vorrichtung nach einem der Ansprüche 10 bis 13, **dadurch gekennzeichnet, dass** die Düsen (24) an dem Flüssigkeitsanschluß (12) mit geringem Abstand dazu angeordnet sind, wobei vorzugsweise zwischen Düse (24) und Flüssigkeitsanschluß (12) das Ventil (17) angeordnet ist.

15. Vorrichtung nach einem der Ansprüche 10 bis 14, **dadurch gekennzeichnet, dass** die Düsen (24) in ihrer Ausrichtung bewegbar bzw. veränderbar sind, wobei vorzugsweise die Düsen (24) einzeln oder in Gruppen veränderbar sind und insbesondere die Gruppen nach Flüssigkeitsanschlüssen (12) aufgeteilt sind.

## Claims

1. A method for treating objects, in particular substrates (29) in the printed circuit board industry, by means of a liquid, whereby:
- the objects (29) have a layer on their surface, which layer layer is partially removed under the influence of the liquid while a pattern is formed,
- several nozzles (24) are provided for discharging the liquid and are connected to at least one liquid connection (12),
- the liquid connection (12) is connected to a liquid reservoir,
**characterized in that**:
- the liquid connection (12) can be opened and closed,
- a valve (17) is provided directly on every nozzle (24),
- the valves (17) can be controlled individually for opening or closing,
- the objects (29) are moved along a path of movement (B) relative to the nozzles (24),
- a specific amount of liquid is discharged with a surface distribution (26), which is predetermined or can be predetermined over a path of movement, by means of opening and closing the valves (17) and/or the liquid connections (12).

2. The method according to Claim 1, **characterized in that** the liquid connections (12) are elongated, have several nozzles (24) spaced from one another, and can be opened and closed each through a lock (27), whereby several liquid connections (12) are arranged parallel to one another and one behind the other in order to cover a surface above the path of movement (B) and can in particular be individually controlled.

3. The method according to Claim 1 or 2, **characterized in that** the liquid connections (12) are arranged one behind the other relative to the path of movement (B), and the objects (29) are moved along the path of movement (B).

4. The method according to one of the preceding claims, **characterized in that** for achieving a specific surface distribution (26) of the liquid discharge over the path of movement (B) the valves (17) of the nozzles (24) are controlled.

5. The method according to Claim 4, **characterized in that** for achieving the surface distribution (26) the valves (17) of the nozzles (24) are exclusively controlled.

6. The method according to one of the Claims 1 to 4, **characterized in that** for achieving the surface distribution (26) in the passage of the objects (29) the nozzles (24) are preadjusted by means of the valves (17) in a first step, and the liquid connections (12) are opened and closed for cycling in a second step.

7. The method according to one of the preceding claims, **characterized in that** for achieving a specific surface distribution (26) of the liquid discharge less liquid is applied to the lateral and/or front and rear outer areas of the objects (29) than in the center area, whereby the liquid discharge is preferably less in amount and time.

8. The method according to one of the preceding claims, **characterized in that** the nozzles (24) are moved or changed in their alignment, whereby the nozzles (24) are preferably changed individually or in groups, and in particular the groups are divided in accordance with liquid connections (12).

9. The method according to one of the preceding claims, **characterized in that** in direction of passage of the objects (29) along the path of movement (B) of the front nozzles (24) only one or few nozzles discharge liquid and in direction of passage increasingly more nozzles, preferably with coverage of a larger surface, discharge liquid.

10. A device for treating of objects, in particular substrates (29) in the printed circuit board industry, by means of a liquid, in particular for carrying out the method according to one of the preceding claims, whereby:
- the objects (29) have a layer on their surface, which layer is partially removed under the influence of the liquid while a pattern is formed,
- several nozzles (24) are provided for discharging the liquid and are connected to at least one liquid connection (12),
- the liquid connection (12) is connected to a liquid reservoir,
**characterized in that**:
- the liquid connection (12) can be opened and closed,
- a valve (17) is provided directly on every nozzle (24),
- the valves (17) can be controlled individually for opening or closing,
- the objects (29) are moved along a path of movement (B) relative to the nozzles (24),
- the valves (17) and/or the liquid connection (12) can be opened and closed in order to produce a specific liquid discharge with a surface distribution (26) predetermined through a path of movement (B).

11. The device according to Claim 10, **characterized in that** the liquid connection (12) is elongated, has several nozzles (24) spaced from one another and can be opened and closed through a lock (27), whereby preferably several liquid connections (12) are arranged parallel to one another and one behind the other for covering a surface above the path of movement (B) and can in particularly be individually controlled.

12. The device according to Claim 10 or 11, **characterized in that** the liquid connections (12) are arranged stationarily one behind the other relative to the path of movement (B), whereby the objects (29) can be moved preferably on a transport path, in particular a roller path, under the liquid connections (12).

13. The device according to one of the Claims 10 to 12, **characterized in that** the valves (17) of the nozzles (24) can be controlled, in particular individually, in order to achieve a specific surface distribution (26) of the discharge of liquid over the path of movement (B).

14. The device according to one of the Claims 10 to 13, **characterized in that** the nozzles (24) are arranged on the liquid connection (12) with a small distance therefrom, whereby the valve (17) is arranged preferably between nozzle (24) and liquid connection (12).

15. The device according to one of the Claims 10 to 14, **characterized in that** the nozzles (24) can be moved or changed in their alignment, whereby the nozzles (24) can preferably be changed individually or in groups, and in particular the groups are divided in accordance with liquid connections (12).

## Revendications

1. Procédé pour le traitement d'objets, en particulier de substrats (29) dans l'industrie des circuits imprimés, à l'aide d'un liquide, sachant que :
- les objets (29) présentent en surface une couche qui est enlevée en partie sous l'effet du liquide et pour former un modèle,
- plusieurs buses (24) sont prévues pour l'application du liquide et reliées à au moins un raccord de liquide (12),
- le raccord de liquide (12) est relié à un réservoir de liquide,
**caractérisé en ce que** :
- il est possible d'ouvrir et fermer le raccord de liquide (12),
- une vanne (17) est prévue directement sur chaque buse (24),
- les vannes (17) peuvent être commandées individuellement pour l'ouverture ou la fermeture,
- les objets (29) sont déplacés relativement au buses (24) le long d'une trajectoire de mouvement (B),
- l'ouverture et la fermeture des vannes (17) et/ou des raccords de liquide (12)
permettent d'appliquer au-dessus de la trajectoire de mouvement une certaine dose de liquide avec une répartition (26) déterminée ou déterminable sur la surface.

2. Procédé selon la revendication 1, **caractérisé en ce que** les raccords de liquide (12) sont longitudinaux, présentent plusieurs buses (24) placées à distance les unes des autres, et peuvent être individuellement fermés et ouverts par l'intermédiaire d'un obturateur (27), sachant que plusieurs raccords de liquide (12) sont placés parallèlement les uns derrière les autres au-dessus de la trajectoire de mouvement (B) pour couvrir une surface et sont en particulier réglables individuellement.

3. Procédé selon la revendication 1 ou 2, **caractérisé en ce que** les raccords de liquide (12) sont disposés les uns derrière les autres de façon fixe relativement à la trajectoire de mouvement (B) et que les objets (29) sont déplacés le long de la trajectoire de mouvement (B).

4. Procédé selon une des revendications précédentes, **caractérisé en ce que** les vannes (17) des buses (24) sont actionnées pour obtenir une répartition en surface (26) définie de l'application de liquide au-dessus de la trajectoire de mouvement (B).

5. Procédé selon la revendication 4, **caractérisé en ce que** seules les vannes (17) des buses (24) sont actionnées pour obtenir la répartition en surface (26).

6. Procédé selon une des revendications 1 à 4, **caractérisé en ce que** les buses (24) sont préréglées dans un premier temps à l'aide des vannes (17) et que les raccords de liquide (12) sont, dans un second temps, ouverts et fermés pour la synchronisation, et ce afin d'obtenir la répartition en surface désirée du liquide (26) lors du passage des objets (29).

7. Procédé selon une des revendications précédentes, **caractérisé en ce que**, pour obtenir une répartition en surface définie du liquide (26), moins de liquide est appliqué sur les zones extérieures latérales et/ou arrière et avant des objets (29) que sur le milieu, sachant que l'application de liquide est diminuée de préférence en temps et en quantité.

8. Procédé selon une des revendications précédentes, **caractérisé en ce que** les buses (24) sont orientées de façon variable, sachant que les changements d'orientation des buses (24) ont lieu de manière individuelle ou en groupe et que les groupes sont en particulier répartis selon les raccords de liquide (12).

9. Procédé selon une des revendications précédentes, **caractérisé en ce que**, dans le sens de passage des objets (29) le long de la trajectoire de mouvement (B), seulement une ou quelques-unes des buses avant (24) applique(nt) du liquide et que, dans le sens de passage, de plus en plus de buses appliquent du liquide, de préférence en couvrant une plus grande surface.

10. Dispositif pour le traitement d'objets, en particulier de substrats (29) dans l'industrie des circuits imprimés, à l'aide d'un liquide, en particulier pour l'exécution du procédé selon une des revendications précédentes, sachant que :
- les objets (29) présentent en surface une couche qui est enlevée en partie sous l'effet du liquide et pour former un modèle,
- plusieurs buses (24) sont prévues pour l'application du liquide et reliées à au moins un raccord de liquide (12),
- le raccord de liquide (12) est relié à un réservoir de liquide,
**caractérisé en ce que** :
- il est possible d'ouvrir et fermer le raccord de liquide (12),
- une vanne (17) est prévue directement sur chaque buse (24),
- les vannes (17) peuvent être commandées individuellement pour l'ouverture ou la fermeture,
- les objets (29) sont déplacés relativement au buses (24) le long d'une trajectoire de mouvement (B),
- les vannes (17) et/ou les raccords de liquide (12) peuvent être ouvert(e)s et fermé(e)s pour appliquer au-dessus de la trajectoire de mouvement (B) une certaine dose de liquide selon une répartition (26) déterminée ou déterminable sur la surface.

11. Dispositif selon la revendication 10, **caractérisé en ce que** le raccord de liquide (12) est longitudinal, présente plusieurs buses (24) placées à distance les unes des autres et peut être fermé et ouvert par l'intermédiaire d'un obturateur (27), sachant que plusieurs raccords de liquide (12) sont de préférence placés parallèlement les uns derrière les autres au-dessus de la trajectoire de mouvement (B) pour couvrir une surface et sont en particulier réglables individuellement.

12. Dispositif selon la revendication 10 ou 11, **caractérisé en ce que** les raccords de liquide (12) sont disposés les uns derrière les autres de façon fixe relativement à la trajectoire de mouvement (B), sachant que les objets (29) sont de préférence déplaçables sous les raccords de liquide (12) sur un tapis de transport, en particulier un transporteur à rouleaux.

13. Dispositif selon une des revendications 10 à 12, **caractérisé en ce que** les vannes (17) des buses (24) sont actionnables, en particulier individuellement, pour obtenir une répartition en surface (26) définie de l'application de liquide au-dessus de la trajectoire de mouvement (B).

14. Dispositif selon une des revendications 10 à 13, **caractérisé en ce que** les buses (24) du raccord de liquide (12) sont disposées à faible distance de celui-ci, sachant que la vanne (17) est disposée de préférence entre la buse (24) et le raccord de liquide (12).

15. Dispositif selon une des revendications 10 à 14, **caractérisé en ce que** les buses (24) sont orientables de façon variable, sachant que l'orientation des buses (24) est modifiable de préférence de manière individuelle ou en groupe et que les groupes sont en particulier répartis selon les raccords de liquide (12).
